# EUROPÄISCHE PATENTANMELDUNG

(11) **EP 0 590 326 A1**
(43) Veröffentlichungstag der Anmeldung: **06.04.1994**
(21) Anmeldenummer: 93113823.4
(22) Anmeldetag: 30.08.1993
(51) Int. Cl.: H03K 19/00, H03K 19/0185

(54) **CMOS-Eingangsstufe**

(30) Priorität: 29.09.1992 EP 92116654
(71) Anmelder: SIEMENS AKTIENGESELLSCHAFT, D-80333 München (DE)
(72) Erfinder: Sommer, Diether, Dipl.-Phys., D-80469 München (DE); Savignac, Dominique, Dr.rer.nat., D-85737 Ismaning (DE)

(57) **Zusammenfassung**

Die erfindungsgemäße CMOS-Eingangsstufe weist Schaltmittel auf (9, 10), die die Schwelle der Schalttransistoren erhöhen bzw. erniedrigen. Dadurch kann die TTL-Spezifikation auch im "Burn-in"-Modus eingehalten werden.

## Beschreibung

Die Erfindung betrifft eine CMOS-Eingangsstufe gemäß dem Oberbegriff des Anspruchs 1.

CMOS-Eingangsstufen sind seit langem bekannt und z. B. in Tietze/Schenk Halbleiterschaltungstechnik 8. Auflage 1986 auf Seite 211 ff näher beschrieben. Die Abbildung 9.36 zeigt einen als derartige Eingangsstufe ausgebildeten CMOS-Inverter. Die Ausgangsspannung dieses Inverters ist in Abhängigkeit der Eingangsspannung entweder gleich der Versorgungsspannung V_{DD} oder gleich Masse, da immer einer der Transistoren T1 oder T2 leitend geschaltet ist.

Um möglichst geringe Ausfallraten zu gewährleisten, werden integrierte Schaltungen nach ihrer Fertigstellung in sogenannten "Burn-in"-Modus betrieben. Dieser "Burn-in"-Modus garantiert sogenannte Frühausfälle durch simulierte Alterung möglichst sofort zu erkennen. Beim "Burn-in"-Modus werden die integrierten Schaltungen mit einer erhöhten Spannung, z. B. 8 Volt betrieben. Dies setzt einen beschleunigten Alterungsprozeß in Gang und die oben erwähnten Frühausfälle können so sehr schnell erkannt werden.

Ein Problem bei einem derartigen Betriebsmodus ist, daß mit der Erhöhung der Versorgungsspannung auch die Schwellen der Eingangsstufen erhöht werden. Insbesondere bei Bausteinen, die extern mit 5 V und intern beispielsweise mit 3,3 V betrieben werden, wird der "Burn-in" in einem Testmode gefahren, wobei die Regulatoren zum Herabsetzen der externen Versorgungsspannung auf 3,3 V ausgeschaltet werden und dadurch die interne Versorgungsspannung gleich der externen wird. Wenn ein Baustein diese Testmöglichkeit aufweist, so kann beim Einschalten nicht sichergestellt werden, daß der Baustein nicht ungewollt in diesen Testmode springt. Ist dies der Fall, dann kann, aufgrund der Schwellenverschiebung der Eingangsstufen, der Baustein nicht mehr, wie spezifiziert, mit TTL-Pegel am jeweiligen Steuereingang in den Grundzustand gebracht werden, weil ein logisches "High" am Eingang nicht mehr erkannt wird. Bei Speicherbausteinen ist dieser Steuereingang beispielsweise RAS und der Grundzustand wird z. B. durch 8 "RAS-only"-Zyklen eingestellt.

Aufgabe der Erfindung ist es daher, eine CMOS-Eingangsstufe anzugeben, die es erlaubt, auch im "Burn-in"-Modus mit erhöhter Versorgungsspannung die TTL-Spezifikation einzuhalten.

Diese Aufgabe wird durch den kennzeichnenden Teil des Anspruchs 1 gelöst. Weiterbildungen sind Kennzeichen der Unteransprüche.

Durch umschaltbare Schwellen der Eingangspuffer einer integrierten Schaltung kann gewährleistet werden, daß auch bei einer erhöhten Versorgungsspannung im "Burn-in"-Modus die Schwelle der Schalttransistoren konstant bleibt.

Die Erfindung wird nachfolgend anhand zweier Figuren näher erläutert. Es zeigen:
- Figur 1: ein erstes Ausführungsbeispiel einer erfindungsgemäßen CMOS-Eingangsstufe mit umschaltbarer Schwelle in n-Kanal-Technik,
- Figur 2: ein zweites Ausführungsbeispiel einer erfindungsgemäßen CMOS-Eingangsstufe mit einer umschaltbaren Schwelle in p-Kanal-Technik.

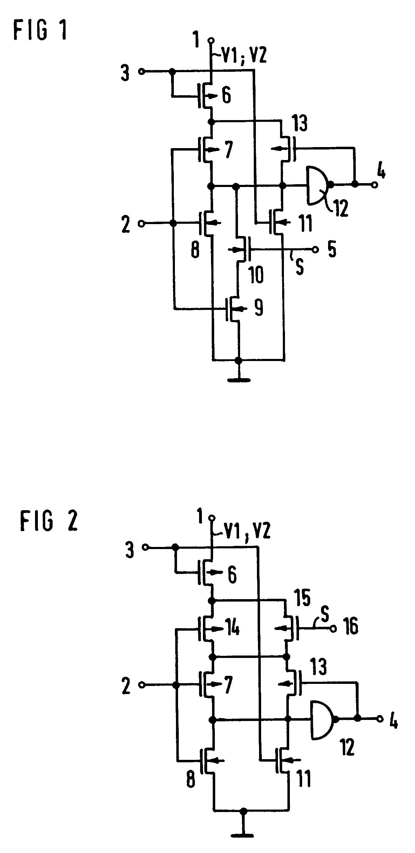

Die in Figur 1 dargestellte Eingangsstufe weist eine Eingangsklemme 1 auf, an welcher die Versorgungsspannung anlegbar ist. Diese Anschlußklemme 1 ist über die Reihenschaltung der Laststrecken zweier p-Kanal-Feldeffekttransistoren 6, 7 und eines n-Kanal-Feldeffekttransistors 8 mit Masse verbunden. Die Laststrecke des n-Kanal-Feldeffekttransistors 8 ist dabei masseseitig geschaltet. Der Gateanschluß des p-Kanal-Feldeffekttransistors 6 ist mit einer Eingangsklemme 3 verschaltet. An dieser Eingangsklemme kann das Enable-Signal angelegt werden. Die Gateanschlüsse des p-Kanal-Feldeffekttransistors 7 und des n-Kanal-Feldeffekttransistors 8 sind miteinander und mit einer Eingangsklemme 2 verschaltet. Die Reihenschaltung der Laststrecken des n-Kanal-Feldeffekttransistors 8 und des p-Kanal-Feldeffekttransistors 7 weisen eine Knotenpunkt auf, welcher mit dem Eingang eines Inverters 12 verschaltet ist. Der Ausgang des Inverters ist mit der Ausgangsklemme 4 und mit dem Gateanschluß eines p-Kanal-Feldeffekttransistors 13 verbunden. Die Laststrecke des p-Kanal-Feldeffekttransistors 13 ist parallel zur Laststrecke des p-Kanal-Feldeffekttransistors 7 geschaltet. Zwischen Eingang des Inverters 12 und Masse ist die Laststrecke eines n-Kanal-Feldeffekttransistors 11 geschaltet. Der Gateanschluß dieses n-Kanal-Feldeffekttransistors 11 ist mit der Anschlußklemme 3 verbunden. Ebenfalls zwischen Eingang des Inverters 12 und Masse ist die Reihenschaltung der Laststrecken zweier n-Kanal-Feldeffekttransistoren 9 und 10 geschaltet. Der Gateanschluß des masseseitig liegenden Feldeffekttransistors 9 ist mit der Eingangsklemme 2 verbunden. Der Gateanschluß des Feldeffekttransistors 10 ist mit einer weiteren Eingangsklemme 5 für ein Schwellenumschaltssignal S verschaltet.

Die eigentliche CMOS-Eingangsstufe wird durch die Transistoren 7 und 8 gebildet. Diese sind in bekannter Weise verschaltet. Die beiden Feldeffekttransistoren 6 und 11 und die zugehörige Anschlußklemme 3 dienen als Enableschaltung und spielen für die Funktion der erfindungsgemäße Anordnung keine Rolle. Der Inverter 12 und der zugehörige rückgekoppelte Feldeffekttransistor 13 stellen eine invertierende Pufferstufe dar, durch welche die gesamte Anordnung zu einer nichtinvertierenden CMOS-Eingangsstufe ausgebildet wird. Diese Elemente stellen eine vorteilhafte Ausgestaltung der Erfindung dar um die Hysterese einzustellen. Die eigentliche erfindungsgemäße Anordnung zur Schwellenänderung besteht aus den beiden Feldeffekttransistoren 9 und 10. Durch diese beiden Feldeffekttransistoren kann der Übergangswiderstand der Laststrecke des Schalttransistors 8 verändert werden.

Liegt an der Eingangsklemme 5 als Schwellenumschaltsignal S ein logisches Nullsignal an, so wird der Feldeffekttransistor 10 deaktiviert und der Feldeffekttransistor 9 spielt fortan für die Schaltungsfunktion keine Rolle mehr. Liegt hingegen an der Eingangsklemme 5 als Schwellenumschaltsignal S ein logisches Einssignal an, so befindet sich der Feldeffekttransistor 10 in leitenden Zustand, wodurch die Laststrecken der Feldeffekttransistoren 8 und 9 quasi parallel geschaltet sind. Dieser Effekt kann dadurch optimiert werden, daß man den Feldeffekttransistor 10 wesentlich größer als den Feldeffekttransitor 9 dimensioniert: Dann ist nämlich beim beschriebenen Schaltungszustand der Feldeffekttransitor 9 fast allein wirksam. Dadurch erniedrigt sich der wirksame Übergangswiderstand zwischen dem Eingang des Inverters 12 und Masse. Durch diese Maßnahmen wird die Schwelle der Eingangsstufe verändert. Bei erhöhter Versorgungsspannung wie z. B. einer Versorgungsspannung von 6 Volt oder von 8 Volt kann durch diese Maßnahme je nach Dimensionierung der Transistoren die Schwelle gegenüber einem Betrieb mit einer Versorgungsspannung von 5 Volt konstant gehalten werden.

Figur 2 zeigt eine erfindungsgemäße Ausführungsform mit einem Schwellenumschalter in p-Kanal-Technik. Gleiche Bauelemente sind mit gleichen Bezugszeichen wie in Figur 1 versehen. So ist eine identische Enable-Schaltungseinrichtung bestehend aus der Anschlußklemme 3 und den beiden Transistoren 6 und 11 vorgesehen. Die Eingangsstufe ist ebenfalls mit der Eingangsklemme 2 und den beiden komplementären Transistoren 7 und 8 dargestellt. Weiterhin ist die invertierende Haltestufe bestehend aus dem Inverter 12 und dem rückgekoppelten Transistor 3 dargestellt. Schließlich ist auch die Ausgangsklemme 4 entsprechend Figur 1 verschaltet.

Die erfindungsgemäße Schwellenschalteinrichtung ist hier durch die beiden Transistoren 14 und 15 realisiert. Über die Anschlußklemme 16 kann das Schwellenumschaltsignal S angelegt werden. Die Laststrecken der in p-Kanal-Technik ausgeführten Schalttransistoren 14 und 15 sind parallel geschaltet. Die parallel geschalteten Laststrecken der Feldeffekttransistoren 14 und 15 sind zwischen die Laststrecke des p-Kanal-Feldeffekttransistors 6 und die Laststrecke des p-Kanal-Feldeffekttransistors 7 geschaltet. Der Gateanschluß des p-Kanal-Feldeffekttransistors 14 ist mit der Eingangsklemme 2 verschaltet und der Gateanschluß des Feldeffekttransistors 15 mit der Anschlußklemme 16.

Liegt an der Anschlußklemme 16 als Schwellenumschaltsignal S ein logisches Nullsignal an, so wird der p-Kanal-Feldeffekttransistors 15 leitend geschaltet. Dadurch wird die Laststrecke des p-Kanal-Feldeffekttransistors 14 mit derjenigen des p-Kanal-Feldeffekttransistors 15 kurzgeschaltet. Dies kann (ähnlich wie bzgl. Figur 1) dadurch optimiert werden, daß man den p-Kanal-Feldeffekttransistor 15 wesentlich größer dimensioniert als den p-Kanal-Feldeffekttransistor 14. Im Falle eines logischen Nullsignals als Schwellenumschaltsignal S bestimmen also im wesentlichen der p-Kanal-Feldeffekttransistor 15 und der p-Kanal-Feldeffekttransistor 7 die Schwelle der CMOS-Eingangsstufe. Liegt dagegen an der Anschlußklemme 16 als Schwellenumschaltsignal S ein logisches Einssignal an, so wird der p-Kanal-Feldeffekttransistor 15 gesperrt und die Laststrecke des p-Kanal-Feldeffekttransistors 14 erhöht nun durch seine Serienschaltung mit dem p-Kanal-Feldeffekttransistor 7 den Übergangswiderstand des p-Kanal-Teiles der CMOS-Eingangsstufe und verändert somit die Schwelle der Eingangsstufe auf ähnliche Weise wie im ersten Ausführungsbeispiel.

Selbstverständlich sind auch andere Schaltungsanordnungen möglich, wesentlich ist, daß die Anordnungen die Schwelle einer Schaltstufe für verschiedene Versorgungsspannungen verändern. Dabei kann die Schwelle des n-Kanal- und/oder die Schwelle des p-Kanal-FET's der Eingangsstufe verändert werden.

Die Ansteuerung der Schwellenschaltvorrichtung über die in Figur 1 und Figur 2 dargestellten Anschlußklemmen 5 und 16 kann automatisch erfolgen durch eine automatische Erkennungsvorrichtung, wie z. B. durch einen Komparator, der so ausgelegt ist, daß er eine erhöhte Versorgungsspannung erkennt, um dann die Schwellenschaltvorrichtung entsprechend anzusteuern. Die Ansteuerung kann jedoch auch manuell erfolgen, indem z. B. im Burn-in-Modus den Anschlußklemmen 5 bzw. 16 ein entsprechendes Schwellenumschaltsignal S zugeführt wird.

Bei Speicherbausteinen eignet sich die Schwellenschaltvorrichtung insbesondere für einen Testmode-Betrieb, der durch sogenanntes "Write CAS before RAS = WCBR" aktiviert wird, wobei durch verschiedene Adressen an den jeweiligen Adresseingängen verschiedene Testmodi eingestellt werden können.

## Patentansprüche

1. CMOS-Eingangsstufe zum Betrieb mit einer Versorgungsspannung, die wahlweise einen ersten Wert (V1) oder einen zweiten, höheren Wert (V2) aufweist, die einen ersten Feldeffekttransistor (7) von einem ersten Leitungstyp und einen zweiten Feldeffekttransistor (8) von einem zweiten Leitungstyp aufweist, deren Laststrecken zwischen einer Versorgungsspannungsklemme (1) und einer Bezugspotentialklemme in Reihe geschaltet sind, wobei im Betrieb an die Versorgungsspannungsklemme (1) wahlweise der erste Wert (V1) oder der zweite Wert (V2) der Versorgungsspannung anlegbar ist, und mit einer Eingangsklemme (2), die mit den Gateanschlüssen der beiden Feldeffekttransistoren (7, 8) verbunden ist,
**dadurch gekennzeichnet,** daß Steuermittel zum Einstellen des Widerstandes der Laststrecke wenigstens von einem der beiden Feldeffekttransistoren (7, 8) vorgesehen sind, wobei das Einstellen in Abhängigkeit vom jeweils gewählten Wert (V1; V2) der Versorgungsspannung erfolgt.

2. CMOS-Eingangsstufe nach Anspruch 1, **dadurch gekennzeichnet,** daß die Steuermittel zwei weitere Feldeffekttransistoren (9, 10) vom zweiten Leitungstyp aufweisen, deren Laststrecken in Reihe parallel zur Laststrecke des zweiten Feldeffekttransistors (8) geschaltet sind, wobei der Gateanschluß des einen der weiteren Feldeffekttransistoren (9) mit der Eingangsklemme (2) verbunden ist und wobei der Gateanschluß des anderen weiteren Feldeffekttransistors (10) mit einer Anschlußklemme (5) für ein Schwellenumschaltsignal (S) verbunden ist.

3. CMOS-Eingangsstufe nach Anspruch 1, **dadurch gekennzeichnet,** daß die Steuermittel zwei weitere Feldeffekttransistoren (14, 15) vom ersten Leitungstyp aufweisen, wobei die Laststrecke der weiteren Feldeffekttransistoren (14, 15) parallel geschaltet sind und versorgungsspannungsseitig zwischen Versorgungsspannungsklemme (1) und der Reihenschaltung der Laststrecken der beiden Feldeffekttransistoren (7, 8) geschaltet sind, wobei der Gateanschluß des einen weiteren Feldeffekttransistors (14) mit der Eingangsklemme (2) und der des anderen weiteren Feldeffekttransistors (15) mit einer Anschlußklemme (16) für ein Schwellenumschaltsignal (S) verbunden ist.

4. CMOS-Pufferstufe mit einer CMOS-Eingangsstufe nach einem der Ansprüche 1 bis 3, **dadurch gekennzeichnet,** daß ausgangsspannungsseitig ein Inverter (12) nachgeschaltet ist, daß parallel zur Laststrecke des ersten Feldeffekttransistors (7) die Laststrecke eines Haltefeldeffekttransistors (13) geschaltet ist, dessen Gateanschluß mit dem Ausgang des Inverters (12) verbunden ist.
